# EUROPEAN PATENT SPECIFICATION

(11) **EP 2 922 207 B1**
(45) Date of publication and mention of the grant of the patent: **29.04.2020**
(21) Application number: 14001075.2
(22) Date of filing: 21.03.2014
(51) Int. Cl.: H03M 1/08, H03M 1/12

(54) **Synchronized charge pump-driven input buffer and method**
Synchronisierter ladungspumpenbetriebener Eingangspuffer und Verfahren
Tampon d'entrée de pompe de charge synchronisée et procédé

(43) Date of publication of application: 23.09.2015
(73) Proprietor: Linear Technology Corporation, Milpitas, CA 95035-7417 (US)
(72) Inventor: Mayes, Michael Keith, Nevada City, CA 95959 (US); Kaplan, Todd Stuart, Grass Valley, CA 95945 (US); Bliss, David Edward, Loomis, CA 95650 (US)
(74) Representative: Müller-Boré & Partner Patentanwälte PartG mbB

(56) References cited:
- JP-A- 2006 121 549
- US-A- 6 002 355
- US-A1- 2012 188 107
- US-B1- 7 515 076
- "Stand-Alone, 4.5-/3.5-Digit Panel Meters with 4-20mA Output", , 31 January 2006 (2006-01-31), pages 1-25, XP055138242, Retrieved from the Internet: URL:http://datasheets.maximintegrated.com/ en/ds/MAX1365-MAX1367.pdf [retrieved on 2014-09-04]
- Oli Josefsson: "Ask the Applications Engineer-16: Using Sigma-Delta Converters, Part 2", , 1 April 1994 (1994-04-01), XP055514281, Retrieved from the Internet: URL:http://www.analog.com/media/en/analog- dialogue/volume-28/number-2/articles/volum e28-number2.pdf#page=24 [retrieved on 2018-10-10]

## Description

### BACKGROUND OF THE INVENTION

### 1. Field of the Invention

The present invention relates to power supply circuits in an integrated circuit. In particular, the present invention relates to providing an on-chip negative power supply circuit that derives a negative voltage based on an externally provided positive supply voltage.

### 2. Discussion of the Related Art

Many applications that use an analog-to-digital (A/D) converter require digitizing signals having voltages that are at ground or below ground. In the prior art, an extra negative bias voltage is required to drive the negative rail of an input buffer to the A/D converter. Providing the additional negative bias voltage adds to the total system cost and complexity. In an integrated circuit, the ability for an on-chip A/D converter to digitize a signal that is at ground or slightly below ground without requiring an externally provided negative power supply voltage is particularly valuable.

Document "Stand-Alone, 4.5-/3.5-Digit Panel Meters with 4-20mA Output", (January 31, 2006; pages 1-25; XP055138242; URL: http://datasheets.maximintegrated.com/en/ds/MAX1365-MAX1367.pdf; retrieved September 4, 2014) discloses the MAX1365/MAX1367 low-power, 4.5- and 3.5-digit, panel meters from Maxim Integrated Products, which feature an integrated sigma-delta analog to-digital converter (ADC), LED display drivers, voltage digital-to-analog converter (DAC), and a 4-20mA (or 0 to 16mA) current driver. The sigma-delta ADC does not require external precision integrating capacitors, auto zero capacitors, crystal oscillators, charge pumps, or other circuitry commonly required in dual-slope ADC panel-meter circuits.

US 6 002 355 A discloses an analog-to-digital converter (ADC) architecture fabricated on a semiconductor substrate, which is negatively capacitively charge pumped below ground and subject to feedback regulation, rate measurements and adjustments. The ADC receives signal inputs of positive and negative polarity relative to ground, while being powered at 0V and 5V, without any negative power source input, as a result of a closed feedback loop which keeps the negative bias voltage constant as external supplies and component voltages vary. The high frequency pumping of the silicon substrate is subject to timing requirements which permit high resolution analog input signals to be converted in the presence of pump noise.

US 7,515,076 describes a method and apparatus for reducing switching noise in a system-on-chip (SoC) integrated circuit including an analog to digital converter (ADC) for reduced noise in the ADC conversions. Sampling circuits of the ADC are operated by sampling clock signals and digital circuits and other noise-generating circuits such as power converters, are operated by digital circuit clock signals. Both sets of clock signals are derived from the same master clock by a clock generator circuit, but an offset is applied in the clock generator circuit to move the edges of the digital circuit clock signals away from critical sampling intervals corresponding to edges of the sampling clocks. In one embodiment, the offset is applied by a processor core that forms part of the digital circuits by setting a value in the clock generator, which the clock generator then loads into the divider after halting the clock to the digital circuits.

JP 2006/121549 describes that a periodic noise frequency fn to be added to an A/D converting means and a sampling frequency fs of the A/D converting means are controlled to the relation of rational numbers, and a sample value system to be outputted from the A/D converting means is subjected to notch filter processing, so that the influence of the periodic noise can be reduced from the system of the sample value to be acquired from the A/D converting means.

US2012/0188107 A1 describes an apparatus that includes a clock source and an oversampled continuous-time digital-to-analog converter. Noise signal is added to the clock signal as the clock signal is generated and/or routed. The oversampled continuous-time digital-to-analog converter includes a sigma-delta modulator to perform noise shaping on input data samples and provide intermediate data samples; a filter to filter the intermediate data samples and generate filtered samples, the filter having a transfer function that has a stop band at a frequency range that includes the frequency of the noise signal or a component of the noise signal; and a continuous-time digital-to-analog converter to convert the filtered samples to an output analog signal.

### SUMMARY

According to one embodiment of the present invention, there is provided an integrated circuit and a method as defined in claims 1 and 9, respectively. Preferred embodiments are set forth in the dependent claims.

According to one embodiment of the present invention, the integrated circuit may include an oscillator circuit providing an oscillator frequency that can be used to create clock signals for both the ADC and the charge pump. In one implementation, the oscillator frequency is an integer multiple of both the clock signal for the ADC and the clock signal for the charge pump. One or more clock divider circuits can be used to generate both the clock signal for the charge pump and the clock signal for the ADC. In one implementation, the ratio of the oscillator frequency to the frequency of the first clock signal and the ratio of the oscillator frequency to the frequency of the second clock signal are relatively prime (e.g., the first clock signal is divided down from the oscillator frequency by a factor of 20, and the second clock signal is divided down from the oscillator frequency by a factor of 19). In another implementation, the ratio of the oscillator frequency to the frequency of the second clock signal is a multiple of 4 that is not divisible by 5. The ratio of the oscillator frequency to the frequency of the second clock signal is a prime number.

In another implementation, the charge pump frequency is chosen so that the ADC conversion time, or other times (e.g., the time delay in one side of a symmetric digital filter) is an integer multiple of a cycle of the charge pump clock signal, so as to cancel, at least n part, timing errors introduced by the charge pump.

The present invention is better understood upon consideration of the detailed description below in conjunction with the accompanying drawings.

### BRIEF DESCRIPTION OF THE DRAWINGS

Figure 1 shows schematically circuit 100 that allows digitizing of a negative signal without an external negative power supply.
Figure 2 shows schematically charge pump circuit 200 of an integrated circuit, in accordance with one embodiment of the present invention.
Figure 3 shows measurements of RMS noise contribution by the charge pump as a function of the divisor N, in a prototype circuit constructed in accordance with one embodiment of the present invention.

### DETAILED DESCRIPTION OF THE PREFERRED EMBODIMENTS

For convenience, the present invention is described in the context of an integrated circuit that is suitable for measuring the voltage of a thermocouple. However, the present invention is not limited to applications requiring thermocouple measurements. The present invention may be used in any suitable application that requires a circuit to process an input signal that is outside a nominal voltage range of the circuit.

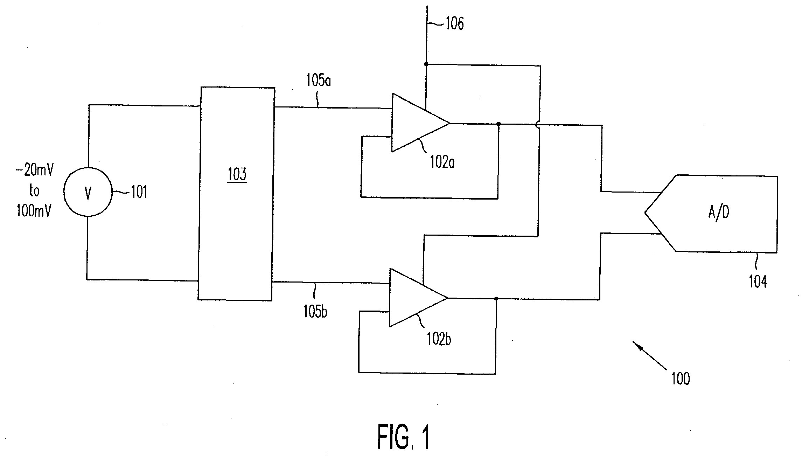

Figure 1 shows schematically circuit 100 that allows digitizing of a negative signal without an external negative power supply. As shown in Figure 1, circuit 100 receives an external signal 101, represented by a voltage source that varies between -20 millivolts (mV) and 100 mV. The input voltage is typically filtered by reverser circuit 103, which may be implemented by a conventional circuit that eliminates any offset voltage in input buffers or amplifiers 102a and 102b and A/D converter 104 to follow. The output signal of reverser circuit 103, which is provided across terminals 105a and 105b, is buffered by unity-gain amplifiers 102a and 102b. The output signals of the input buffers 102a and 102b are then provided to A/D converter 104 for digitizing. To allow digitizing a slightly negative signal, input buffers 102a and 102b has a negative power supply driven by a periodic signal that varies between -200 mV and -180 mV. The periodic signal may be generated by a charge pump. However, such a charge pump is typically operated using a clock-fed switched capacitor network, so that the -200 mV signal generated by the charge pump has several millivolts of clock feed-through noise. Without careful selection of the clock signal's frequency, this significant clock feed-through is introduced to the input signal path. Such interference renders driving the input buffers 102a and 102b directly with the charge pump-generated clock signal untenable.

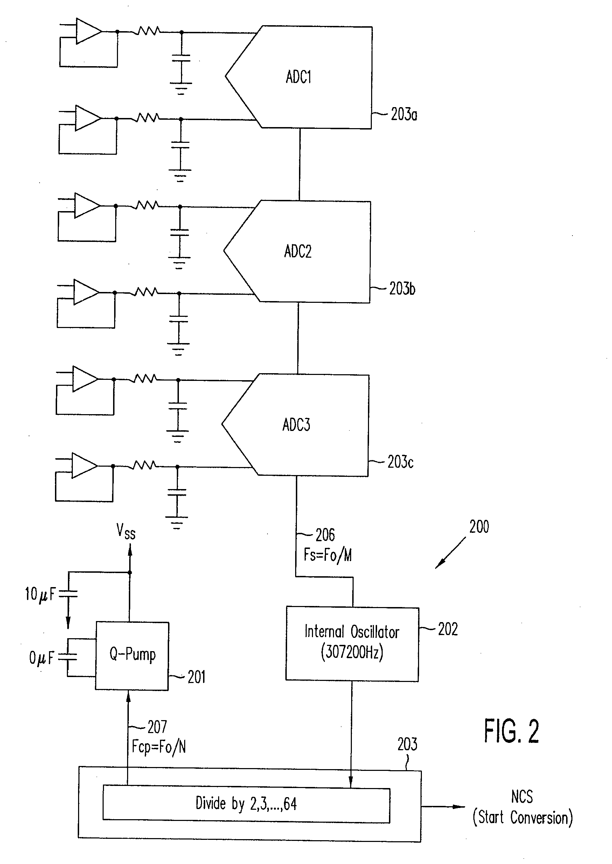

Therefore, according to one embodiment of the present invention, the frequency of the charge pump clock signal is selected such that the noise generated by the operation of the charge pump essentially fall within the rejection band of the A/D converter's digital filter. This approach is illustrated, for example, in the schematic circuit of Figure 2. Figure 2 shows schematically charge pump circuit 200 of an integrated circuit, in accordance with one embodiment of the present invention. As shown in Figure 2, clock signal 206 is generated from internal oscillator 202 to operate delta-sigma A/D converter 203, represented by A/D converter circuits 203a, 203b and 203c. In one embodiment, clock signal 206 is divided down by a factor M (e.g., M equals 20) in divider circuit 203 from internal oscillator 202's frequency of F₀ (e.g., 307.2 KHz). At the same time, charge pump circuit 201 is fed by clock signal 207, which is divided down in divider 203 from frequency F₀ by a factor N. Clock signal 207 may be used to control the input buffers (e.g., input buffers 102a and 102b of Figure 1) to delta-sigma A/D converter 203. Charge pump circuit 201 may be implemented, for example, by a conventional charge pump circuit. Divider circuit 203 may enjoy a simpler design if the values of M and N are integers.

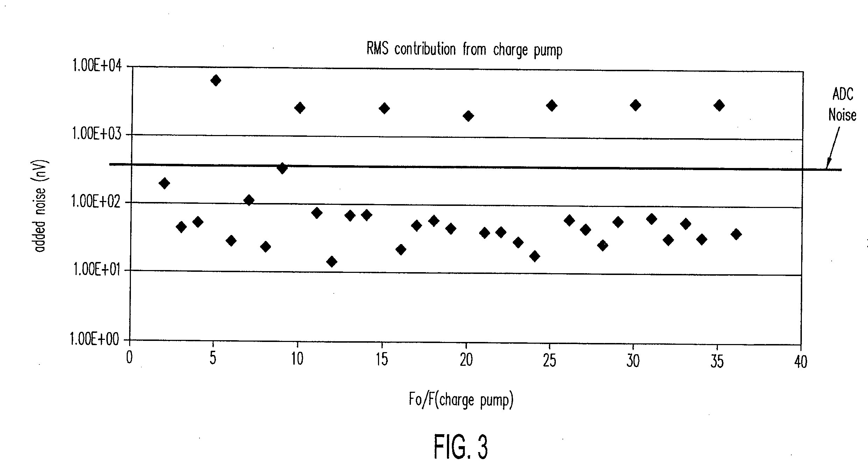

The value of N may be selected from a characterization of delta-sigma A/D converter 203's noise characteristics as a function of clock signal 207. Figure 3 shows measurements of RMS noise contribution by the charge pump as a function of the divisor N, in a prototype circuit constructed in accordance with one embodiment of the present invention. The prototype implements schematic circuit 200 of Figure 2, with divider 203 being implemented by a suitable clock divider (e.g., a conventional programmable clock divider that allows dividing down by an integral factor between 2 and 63). The results of Figure 3 show that any prime number greater than 10 would introduce less than average noise (i.e., below the average ADC noise line in Figure 3). In addition, many multiples of 4 that are not divisible by 5(e.g., 8, 12,16, 24, 28, 32) also provide lower than average noise. Accordingly, one suitable value for N is 19. It would also be particularly beneficial if harmonics of the selected clock signal frequency is also within the rejection band of the delta-sigma A/D converter.

By forcing the charge pump sampling frequency into the rejection nulls of sigma-delta A/D converter 203's digital filter, clock feed-through interference is attenuated. As a result, buffer amplifiers (e.g., input buffers 102a and 102b of Figure 1) may be operated with charge pump signal 207 to allow signals at ground or below ground to be digitized by delta-sigma A/D converter 203 without requiring an external negative power supply voltage. Furthermore, by measuring the total error over the entire input range at various temperatures when operating under the selected charge pump frequency and comparing it the total error when the charge pump circuit is not used (i.e., by providing an external negative power supply voltage), the selected charge pump frequency can be varied to attenuate the error introduced by charge pump clock signal 207.

The detailed description above is provided to illustrate specific embodiments of the present invention and is not intended to be limiting. Numerous modifications and variations within the scope of the present invention are possible. The present invention is set forth in the accompanying claims.

## Claims

1. An integrated circuit (100), comprising:
an analog-to-digital converter (104, 203a, 203b, 203c) operated according to a first clock signal (206), the first clock signal (206) having a first frequency, the analog-to-digital converter (104, 203a, 203b, 203c) being a sigma-delta analog-to-digital converter, a digital filter of the analog-to-digital converter (104, 203a, 203b, 203c) having a frequency rejection band and the analog-to digital converter (104, 203a, 203b, 203c) producing a digital output signal based on an analog input signal; and
a charge pump circuit (201) providing a negative power supply voltage to the integrated circuit (100), the charge pump circuit (201) being operated according to a second clock signal (207) having a second frequency that is different from the first frequency of the first clock signal (206),
wherein the second frequency, for operating the charge pump circuit (201), is selected to be within the frequency rejection band of the analog-to-digital converter's (104, 203a, 203b, 203c) digital filter and within rejection nulls of the analog-to-digital converter's (104, 203a, 203b, 203c) digital filter, such that a noise effect on the digital output signal of noise introduced by the charge pump circuit (201) is attenuated by the frequency rejection of the analog-to-digital converter (104, 203a, 203b, 203c);
wherein the integrated circuit (100) further comprises a frequency divider circuit (203) that receives a master clock signal and that, based on the master clock signal, generates both the first clock signal (206) and the second clock signal (207); and
wherein the ratio of the master clock signal frequency to the frequency of the second clock signal is a prime number.

2. The integrated circuit (100) of Claim 1, further comprising an oscillator circuit (202) that generates the master clock signal (F₀) at a frequency that can be divided down to generate the second frequency such that the second frequency is within the frequency rejection band of the analog-to-digital converter's (104, 203a, 203b, 203c)

3. The integrated circuit (100) of Claim 1, wherein a harmonic of the frequency of the second clock signal (207) is within a rejection band of the analog-to-digital converter's (104, 203a, 203b, 203c) digital filter.

4. The integrated circuit (100) of Claim 1, wherein the frequency divider circuit (203) comprises a programmable clock divider that is programmable to generate the second frequency selected to be within the frequency rejection band of the analog-to-digital converter's (104, 203a, 203b, 203c) digital filter.

5. The integrated circuit (100) of Claim 1, wherein the second frequency is selected such that one or more harmonics of the second frequency are located in one or more rejection frequency nulls of the digital filter provided by the sigma-delta analog-to-digital converter (203a, 203b, 203c).

6. The integrated circuit (100) of Claim 1, comprising a buffer amplifier (102a, 102b) arranged to buffer an analog input signal for providing a buffered analog input signal to the analog-to-digital converter (104, 203a, 203b, 203c), wherein the buffer amplifier (102a, 102b) and the analog-to-digital converter (104, 203a, 203b, 203c) are both coupled to the charge pump circuit (201) to receive a negative supply voltage from the charge pump circuit (201) for operating the buffer amplifier (102a, 102b) and the analog-to-digital converter (104, 203a, 203b, 203c) in a normal mode of operation without requiring an external negative power supply voltage.

7. A method for providing a reduced noise power supply circuit for a sigma-delta analog-to-digital converter (104, 203a, 203b, 203c), comprising:
providing a first clock signal (206) of a first frequency to operate the analog-to-digital converter (104, 203a, 203b, 203c) to produce a digital output signal based on an analog input signal, a digital filter of the analog-to-digital converter (104, 203a, 203b, 203c) having a frequency rejection band; and
providing a second clock signal (207) of a second frequency different from the first frequency to operate a charge pump circuit (201) that generates a negative power supply voltage provided to the analog-to-digital converter (104, 203a, 203b, 203c),
wherein the second frequency, for operating the charge pump circuit (201), is selected to be within the frequency rejection band of the analog-to-digital converter's (104, 203a, 203b, 203c) digital filter and within rejection nulls of the analog-to-digital converter's (104, 203a, 203b, 203c) digital filter, such that a noise effect on the digital output signal of noise introduced by the charge pump circuit (201) is attenuated by the frequency rejection of the analog-to-digital converter (104, 203a, 203b, 203c);
wherein the first clock signal (206) and the second clock signal (207) are generated by dividing from a master clock signal); and
wherein the ratio of the master clock signal frequency to the frequency of the second clock signal is a prime number.

8. The method of Claim 7, wherein dividing the frequency divider circuit (203) of the master clock signal comprises using a programmable clock divider programmed such that the second frequency is within the frequency rejection band of the analog-to-digital converter's (104, 203a, 203b, 203c) digital filter.

9. The method of Claim 7, wherein a harmonic of the second frequency is within a rejection band of the analog-to-digital converter's (104, 203a, 203b, 203c) digital filter.

10. The method of claim 7, wherein the second frequency is selected such that one or more harmonics of the second frequency are located in one or more rejection frequency nulls of the digital filter provided by the sigma-delta analog-to-digital converter (203a, 203b, 203c).

11. The method of claim 10, comprising buffering, by a buffer amplifier (102a, 102b), an analog input signal for providing a buffered analog input signal to the analog-to-digital converter (104, 203a, 203b, 203c), wherein the buffer amplifier (102a, 102b) and the analog-to-digital converter (104, 203a, 203b, 203c) are both coupled to the charge pump circuit (201) and receive a negative supply voltage from the charge pump circuit (201) for operating the buffer amplifier (102a, 102b) and the analog-to-digital converter (104, 203a, 203b, 203c) in a normal mode of operation without requiring an external negative power supply voltage.

## Patentansprüche

1. Integrierte Schaltung (100), umfassend:
einen Analog-Digital-Wandler (104, 203a, 203b, 203c), der gemäß einem ersten Taktsignal (206) betrieben wird, wobei das erste Taktsignal (206) eine erste Frequenz aufweist, wobei der Analog-Digital-Wandler (104, 203a, 203b, 203c) ein Sigma-Delta-Analog-Digital-Wandler ist, ein digitales Filter des Analog-Digital-Wandlers (104, 203a, 203b, 203c) ein Frequenzunterdrückungsband aufweist und der Analog-Digital-Wandler (104, 203a, 203b, 203c) ein digitales Ausgangssignal basierend auf einem analogen Eingangssignal erzeugt; und
eine Ladungspumpenschaltung (201), die der integrierten Schaltung (100) eine negative Leistungsversorgungsspannung bereitstellt, wobei die Ladungspumpenschaltung (201) gemäß einem zweiten Taktsignal (207) betrieben wird, das eine zweite Frequenz aufweist, die sich von der ersten Frequenz des ersten Taktsignals (206) unterscheidet,
wobei die zweite Frequenz für den Betrieb der Ladungspumpenschaltung (201) ausgewählt ist, um innerhalb des Frequenzunterdrückungsbandes des digitalen Filters des Analog-Digital-Wandlers (104, 203a, 203b, 203c) und innerhalb von Unterdrückungsnullen des digitalen Filters des Analog-Digital-Wandlers (104, 203a, 203b, 203c) zu liegen, derart dass eine Rauschwirkung auf das digitale Ausgangssignal von Rauschen, das von der Ladungspumpenschaltung (201) eingeführt wird, von der Frequenzunterdrückung des Analog-Digital-Wandlers (104, 203a, 203b, 203c) gedämpft wird;
wobei die integrierte Schaltung (100) überdies eine Frequenzteilerschaltung (203) umfasst, die ein Haupttaktsignal empfängt und die basierend auf dem Haupttaktsignal sowohl das erste Taktsignal (206) als auch das zweite Taktsignal (207) erzeugt; und
wobei das Verhältnis der Haupttaktsignalfrequenz zur Frequenz des zweiten Taktsignals eine Primzahl ist.

2. Integrierte Schaltung (100) nach Anspruch 1, die überdies eine Oszillatorschaltung (202) umfasst, die das Haupttaktsignal (F₀) bei einer Frequenz erzeugt, die herunter geteilt werden kann, um die zweite Frequenz derart zu erzeugen, dass die zweite Frequenz innerhalb des Frequenzunterdrückungsbandes des digitalen Filters des Analog-Digital-Wandlers (104, 203a, 203b, 203c) liegt.

3. Integrierte Schaltung (100) nach Anspruch 1, wobei eine Oberwelle der Frequenz des zweiten Taktsignals (207) innerhalb eines Unterdrückungsbandes des digitalen Filters des Analog-Digital-Wandlers (104, 203a, 203b, 203c) liegt.

4. Integrierte Schaltung (100) nach Anspruch 1, wobei die Frequenzteilerschaltung (203) einen programmierbaren Taktteiler umfasst, der programmierbar ist, um die zweite Frequenz zu erzeugen, die ausgewählt wird, um innerhalb des Frequenzunterdrückungsbandes des digitalen Filters des Analog-Digital-Wandlers (104, 203a, 203b, 203c) zu liegen.

5. Integrierte Schaltung (100) nach Anspruch 1, wobei die zweite Frequenz derart ausgewählt wird, dass eine oder mehrere Oberwellen der zweiten Frequenz sich in einer oder mehreren Unterdrückungsfrequenznullen des digitalen Filters befinden, das von dem Sigma-Delta-Analog-Digital-Wandler (203a, 203b, 203c) bereitgestellt wird.

6. Integrierte Schaltung (100) nach Anspruch 1, die ferner einen Pufferverstärker (102a, 102b) umfasst, der angeordnet ist, um ein analoges Eingangssignal zu puffern, um dem Analog-Digital-Wandler (104, 203a, 203b, 203c) ein gepuffertes analoges Eingangssignal bereitzustellen, wobei der Pufferverstärker (102a, 102b) und der Analog-Digital-Wandler (104, 203a, 203b, 203c) beide an die Ladungspumpenschaltung (201) gekoppelt sind, um eine negative Versorgungsspannung von der Ladungspumpenschaltung (201) zu empfangen, um den Pufferverstärker (102a, 102b) und den Analog-Digital-Wandler (104, 203a, 203b, 203c) in einem normalen Betriebsmodus zu betreiben, ohne dass eine externe negative Leistungsversorgungsspannung erforderlich ist.

7. Verfahren zum Bereitstellen einer Leistungsversorgungsschaltung mit verringertem Rauschen für einen Sigma-Delta-Analog-Digital-Wandler (104, 203a, 203b, 203c), umfassend:
Bereitstellen eines ersten Taktsignals (206) mit einer ersten Frequenz zum Betreiben des Analog-Digital-Wandlers (104, 203a, 203b, 203c) zum Erzeugen eines digitalen Ausgangssignals basierend auf einem analogen Eingangssignal, wobei ein digitales Filter des Analog-Digital-Wandlers (104, 203a, 203b, 203c) ein Frequenzunterdrückungsband aufweist; und
Bereitstellen eines zweiten Taktsignals (207) mit einer zweiten Frequenz, die sich von der ersten Frequenz unterscheidet, zum Betreiben einer Ladungspumpenschaltung (201), die eine negative Leistungsversorgungsspannung erzeugt, die dem Analog-Digital-Wandler (104, 203a, 203b, 203c) bereitgestellt wird,
wobei die zweite Frequenz zum Betreiben der Ladungspumpenschaltung (201) ausgewählt wird, um innerhalb des Frequenzunterdrückungsbandes des digitalen Filters des Analog-Digital-Wandlers (104, 203a, 203b, 203c) und innerhalb von Unterdrückungsnullen des digitalen Filters des Analog-Digital-Wandlers (104, 203a, 203b, 203c) zu liegen, derart dass eine Rauschwirkung auf das digitale Ausgangssignal von Rauschen, das von der Ladungspumpenschaltung (201) eingeführt wird, von der Frequenzunterdrückung des Analog-Digital-Wandlers (104, 203a, 203b, 203c) gedämpft wird;
wobei das erste Taktsignal (206) und das zweite Taktsignal (207) durch Teilen von einem Haupttaktsignal erzeugt werden; und
wobei das Verhältnis der Haupttaktsignalfrequenz zur Frequenz des zweiten Taktsignals eine Primzahl ist.

8. Verfahren nach Anspruch 7, wobei das Teilen der Frequenzteilerschaltung (203) des Haupttaktsignals das Verwenden eines programmierbaren Taktteilers umfasst, der derart programmiert ist, dass die zweite Frequenz innerhalb des Frequenzunterdrückungsbandes des digitalen Filters des Analog-Digital-Wandlers (104, 203a, 203b, 203c) liegt.

9. Verfahren nach Anspruch 7, wobei eine Oberwelle der zweiten Frequenz innerhalb eines Unterdrückungsbandes des digitalen Filters des Analog-Digital-Wandlers (104, 203a, 203b, 203c) liegt.

10. Verfahren nach Anspruch 7, wobei die zweite Frequenz derart ausgewählt wird, dass eine oder mehrere Oberwellen der zweiten Frequenz sich in einer oder mehreren Unterdrückungsfrequenznullen des digitalen Filters befinden, die von dem Sigma-Delta-Analog-Digital-Wandler (203a, 203b, 203c) bereitgestellt werden.

11. Verfahren nach Anspruch 10, das das Puffern eines analogen Eingangssignals durch einen Pufferverstärker (102a, 102b) umfasst, um dem Analog-Digital-Wandler (104, 203a, 203b, 203c) ein gepuffertes analoges Eingangssignal bereitzustellen, wobei der Pufferverstärker (102a, 102b) und der Analog-Digital-Wandler (104, 203a, 203b, 203c) beide an die Ladungspumpenschaltung (201) gekoppelt sind und eine negative Versorgungsspannung von der Ladungspumpenschaltung (201) zum Betreiben des Pufferverstärkers (102a, 102b) und des Analog-Digital-Wandlers (104, 203a, 203b, 203c) in einem normalen Betriebsmodus empfangen, ohne dass eine externe negative Leistungsversorgungsspannung erforderlich ist.

## Revendications

1. Circuit intégré (100) comprenant :
un convertisseur analogique-numérique (104, 203a, 203b, 203c) fonctionnant selon un premier signal d'horloge (206), le premier signal d'horloge (206) ayant une première fréquence, le convertisseur analogique-numérique (104, 203a, 203b, 203c) étant un convertisseur analogique-numérique sigma-delta, un filtre numérique du convertisseur analogique-numérique (104, 203a, 203b, 203c) ayant une bande de réjection de fréquence et le convertisseur analogique-numérique (104, 203a, 203b, 203c) produisant un signal de sortie numérique basé sur un signal d'entrée analogique ; et
un circuit de pompe de charge (201) fournissant une tension d'alimentation électrique négative au circuit intégré (100), le circuit de pompe de charge (201) fonctionnant selon un second signal d'horloge (207) ayant une seconde fréquence qui est différente de la première fréquence du premier signal d'horloge (206),
dans lequel la seconde fréquence, pour faire fonctionner le circuit de pompe de charge (201), est sélectionnée pour se situer à l'intérieur de la bande de réjection de fréquence du filtre numérique du convertisseur analogique-numérique (104, 203a, 203b, 203c) et à l'intérieur de valeurs nulles de réjection du filtre numérique du convertisseur analogique-numérique (104, 203a, 203b, 203c), de sorte qu'un effet de bruit sur le signal de sortie numérique du bruit introduit par le circuit de pompe de charge (201) est atténué par le rejet de fréquences du convertisseur analogique-numérique (104, 203a, 203b, 203c);
dans lequel le circuit intégré (100) comprend en outre un circuit diviseur de fréquence (203) qui reçoit un signal d'horloge maître et qui, basé sur le signal d'horloge maître, génère à la fois le premier signal d'horloge (206) et le second signal d'horloge (207) ; et
dans lequel le rapport de la fréquence du signal d'horloge maître à la fréquence du second signal d'horloge est un nombre premier.

2. Circuit intégré (100) selon la revendication 1, comprenant en outre un circuit oscillant (202) qui génère le signal d'horloge maître (F₀) à une fréquence qui peut être divisée pour générer la seconde fréquence de sorte que la seconde fréquence se situe à l'intérieur de la bande de réjection de fréquence du filtre numérique du convertisseur analogique-numérique (104, 203a, 203b, 203c).

3. Circuit intégré (100) selon la revendication 1, dans lequel une harmonique de la fréquence du second signal d'horloge (207) se situe à l'intérieur d'une bande de réjection du filtre numérique du convertisseur analogique-numérique (104, 203a, 203b, 203c).

4. Circuit intégré (100) selon la revendication 1, dans lequel le circuit diviseur de fréquence (203) comprend un diviseur d'horloge programmable qui peut être programmé pour générer la seconde fréquence sélectionnée pour se situer à l'intérieur de la bande de réjection de fréquence du filtre numérique du convertisseur analogique-numérique (104, 203a, 203b, 203c).

5. Circuit intégré (100) selon la revendication 1, dans lequel la seconde fréquence est sélectionnée de sorte qu'une ou plusieurs harmoniques de la seconde fréquence sont situées dans au moins une valeur nulle de fréquence de réjection du filtre numérique fourni par le convertisseur analogique-numérique sigma-delta (203a, 203b, 203c).

6. Circuit intégré (100) selon la revendication 1, comprenant un amplificateur tampon (102a, 102b) placé pour tamponner un signal d'entrée analogique pour fournir un signal d'entrée analogique tamponné au convertisseur analogique-numérique (104, 203a, 203b, 203c), dans lequel l'amplificateur tampon (102a, 102b) et le convertisseur analogique-numérique (104, 203a, 203b, 203c) sont tous deux couplés au circuit de pompe de charge (201) pour recevoir une tension d'alimentation négative du circuit de pompe de charge (201) pour faire fonctionner l'amplificateur tampon (102a, 102b) et le convertisseur analogique-numérique (104, 203a, 203b, 203c) dans un mode normal de fonctionnement sans nécessiter une tension d'alimentation électrique négative externe.

7. Procédé de fourniture d'un circuit d'alimentation électrique à bruit réduit pour un convertisseur analogique-numérique sigma-delta (104, 203a, 203b, 203c), comprenant :
la fourniture d'un premier signal d'horloge (206) d'une première fréquence pour faire fonctionner le convertisseur analogique-numérique (104, 203a, 203b, 203c) pour produire un signal de sortie numérique basé sur un signal d'entrée analogique, un filtre numérique du convertisseur analogique-numérique (104, 203a, 203b, 203c) ayant une bande de réjection de fréquence ; et
la fourniture d'un second signal d'horloge (207) d'une seconde fréquence différente de la première fréquence pour faire fonctionner un circuit de pompe de charge (201) qui génère une tension d'alimentation électrique négative fournie au convertisseur analogique-numérique (104, 203a, 203b, 203c),
dans lequel la seconde fréquence, pour faire fonctionner le circuit de pompe de charge (201), est sélectionnée pour se situer à l'intérieur de la bande de réjection de fréquence du filtre numérique du convertisseur analogique-numérique (104, 203a, 203b, 203c) et à l'intérieur de valeurs nulles de réjection du filtre numérique du convertisseur analogique-numérique (104, 203a, 203b, 203c), de sorte qu'un effet de bruit sur le signal de sortie numérique du bruit introduit par le circuit de pompe de charge (201) est atténué par le rejet de fréquences du convertisseur analogique-numérique (104, 203a, 203b, 203c);
dans lequel le premier signal d'horloge (206) et le second signal d'horloge (207) sont générés par une division d'un signal d'horloge maître ; et
dans lequel le rapport de la fréquence du signal d'horloge maître à la fréquence du second signal d'horloge est un nombre premier.

8. Procédé selon la revendication 7, dans lequel la division du circuit diviseur de fréquence (203) du signal d'horloge maître comprend l'utilisation d'un diviseur d'horloge programmable de sorte que la seconde fréquence se situe à l'intérieur de la bande de réjection de fréquence du filtre numérique du convertisseur analogique-numérique (104, 203a, 203b, 203c).

9. Procédé selon la revendication 7, dans lequel une harmonique de la seconde fréquence se situe à l'intérieur d'une bande de réjection du filtre numérique du convertisseur analogique-numérique (104, 203a, 203b, 203c).

10. Procédé selon la revendication 7, dans lequel la seconde fréquence est sélectionnée de sorte qu'une ou plusieurs harmoniques de la seconde fréquence sont situées dans au moins une valeur nulle de fréquence de réjection du filtre numérique fourni par le convertisseur analogique-numérique sigma-delta (203a, 203b, 203c).

11. Procédé selon la revendication 10, comprenant la mise en tampon, par un amplificateur tampon (102a, 102b), d'un signal d'entrée analogique pour fournir un signal d'entrée analogique tamponné au convertisseur analogique-numérique (104, 203a, 203b, 203c), dans lequel l'amplificateur tampon (102a, 102b) et le convertisseur analogique-numérique (104, 203a, 203b, 203c) sont tous deux couplés au circuit de pompe de charge (201) et reçoivent une tension d'alimentation négative du circuit de pompe de charge (201) pour faire fonctionner l'amplificateur tampon (102a, 102b) et le convertisseur analogique-numérique (104, 203a, 203b, 203c) dans un mode normal de fonctionnement sans nécessiter une tension d'alimentation électrique négative externe.
